# EUROPEAN PATENT APPLICATION

(11) **EP 4 517 835 A1**
(43) Date of publication of application: **05.03.2025**
(21) Application number: 23884113.4
(22) Date of filing: 28.04.2023
(51) Int. Cl.: H01L 29/786

(54) **THIN FILM TRANSISTOR AND MANUFACTURING METHOD THEREFOR, DISPLAY SUBSTRATE, AND DISPLAY APPARATUS**

(30) Priority: 31.10.2022 CN 202211353473
(71) Applicant: Boe Technology Group Co., Ltd., Beijing 100015 (CN)
(72) Inventor: WANG, Dongfang, Beijing 100176 (CN); YANG, Jin, Beijing 100176 (CN); LI, Peirou, Beijing 100176 (CN); WANG, Haoran, Beijing 100176 (CN)
(74) Representative: Cohausz & Florack
(86) International application number: PCT/CN2023/091627
(87) International publication number: WO 2024/093171

(57) **Abstract**

A thin film transistor, a method for manufacturing a thin film transistor, a display substrate and a display apparatus are provided. The thin film transistor includes: a gate electrode, an active layer, a source electrode and a drain electrode on the substrate, wherein the active layer is on a side of the source electrode away from the substrate, the gate electrode is on a side of the active layer away from the substrate, and the source electrode and the drain electrode are connected to the active layer; a buffer layer between layers where the active layer and the source electrode are located; a gate insulating layer between layers where the active layer and the gate electrode are located, and including a hollowed-out portion therein, and an adapter electrode on a side of the active layer away from the substrate, wherein one part of the adapter electrode is electrically connected to the active layer through the hollowed-out portion and the other part of the adapter electrode is electrically connected to the source electrode through a first via. The first via at least extends through the active layer and the buffer layer. An orthographic projection of the first via on the substrate overlaps with an orthographic projection of the hollowed-out portion on the substrate.

## Description

### TECHNICAL FIELD

The present disclosure relates to the field of display technology, and in particular to a thin film transistor, a method for manufacturing a thin film transistor, a display substrate and a display apparatus.

### BACKGROUND

Conductive structures in different layers are required to be electrically connected to each other through vias in a display substrate. The vias are formed through a patterning process, and a size of the vias affects a resolution, a frame size, a transmittance and the like of a product.

### SUMMARY

The present disclosure provides a thin film transistor, a method for manufacturing a thin film transistor, a display substrate and a display apparatus.

In a first aspect, the present disclosure provides a thin film transistor, including: a gate electrode, an active layer, a source electrode and a drain electrode on the substrate, wherein the active layer is on a side of the source electrode away from the substrate, the gate electrode is on a side of the active layer away from the substrate, and the source electrode and the drain electrode are connected to the active layer; a buffer layer between layers where the active layer and the source electrode are located; a gate insulating layer between layers where the active layer and the gate electrode are located, and including a hollowed-out portion therein, and an adapter electrode on a side of the active layer away from the substrate, wherein one part of the adapter electrode is electrically connected to the active layer through the hollowed-out portion and the other part of the adapter electrode is electrically connected to the source electrode through a first via, wherein the first via at least extends through the active layer and the buffer layer, and an orthographic projection of the first via on the substrate overlaps with an orthographic projection of the hollowed-out portion on the substrate.

In some embodiments, the hollowed-out portion is a second via extending through the gate insulating layer, the orthographic projection of the first via on the substrate is a first projection, and an orthographic projection of the second via on the substrate is a second projection; and the first projection is within the second projection; or one part of the second projection is within the first projection, and the other part of the second projection is outside the first projection.

In some embodiments, an orthographic projection of the adapter electrode on the substrate covers the second projection.

In some embodiments, the adapter electrode is in the same layer as the gate electrode.

In some embodiments, the adapter electrode and the gate electrode are arranged in a first direction; and a distance between the adapter electrode and the gate electrode in the first direction is in a range from 1µm to 3µm.

In some embodiments, the thin film transistor further includes: a light-shielding member between the active layer and the substrate, and an orthographic projection of the light-shielding member on the substrate at least partially overlaps with an orthographic projection of the active layer on the substrate.

In some embodiments, the hollowed-out portion is a second via extending through the gate insulating layer; and the orthographic projection of the light-shielding member on the substrate partially overlaps with the orthographic projection of the second via on the substrate.

In some embodiments, the orthographic projection of the light-shielding member on the substrate overlaps with an orthographic projection of the adapter electrode on the substrate.

In some embodiments, the light-shielding member is in the same layer as the source electrode.

In some embodiments, the light-shielding member and the source electrode are arranged in a first direction; and a distance between the light-shielding member and the source electrode in the first direction is in a range from 1µm to 3µm.

In some embodiments, the active layer includes a first conductive portion through which the first via extends, a second conductive portion serving as the drain electrode, and a channel portion between the first conductive portion and the second conductive portion.

In some embodiments, the channel portion and the second conductive portion are arranged in a first direction, and the first conductive portion is strip-shaped and extends along the first direction.

In some embodiments, a distance between an orthographic projection of a portion of the first conductive portion, which is in contact with the adapter electrode, on the substrate and an orthographic projection of the channel portion on the substrate in the first direction is in a range from 1µm to 4µm.

In some embodiments, a portion of the adapter electrode connected to the active layer through the hollowed-out portion and a portion of the adapter electrode connected to the source electrode through the first via are arranged in a first direction.

In some embodiments, an aperture of an end of the first via close to the substrate is less than 2µm; and the buffer layer includes a first portion covered by the active layer and a second portion not in contact with the active layer, the first portion has a first slope surface close to the first via and having a slope angle in a range from 70° to 90°, and the second portion has a second slope surface close to the first via and having a slope angle less than or equal to 60°.

In some embodiments, an orthographic projection of a bottom of the first via on the substrate is within a region covered by an orthographic projection of the source electrode on the substrate; and a difference between a length of the source electrode in the first direction and a length of the bottom of the first via in the first direction is greater than or equal to 0.5µm.

In some embodiments, the buffer layer includes a protrusion portion covering a portion of the source electrode close to the channel portion of the active layer.

In some embodiments, a thickness of the protrusion portion in a direction perpendicular to the substrate is in a range from 1000µm to 20000µm.

In some embodiments, a surface of the protrusion portion away from the substrate is an arc surface having a radian in a range from 15° to 90°.

In some embodiments, a portion of the adapter electrode in the first via is a third portion; and a surface of the third portion away from the substrate is a convex surface protruding away from the substrate.

In some embodiments, a difference between a maximum thickness and a minimum thickness of the third portion in the direction perpendicular to the substrate is in a range from 0.3µm to 0.6µm.

In some embodiments, the hollowed-out portion is a second via through the gate insulating layer; and a difference between a slope angle of a slope surface of the gate insulating layer close to the second via and a slope angle of a slope surface of the active layer close to the first via is greater than or equal to 0° and less than or equal to 30°, and the slope surface of the gate insulating layer and the slope surface of the active layer are on the same side.

In some embodiments, the active layer is made of a metal oxide.

In a second aspect, the present disclosure further provides a display substrate, including the thin film transistor provided in the first aspect.

In some embodiments, the display substrate includes: a plurality of gate lines extending in the first direction and a plurality of data lines extending in a second direction on the substrate, which intersect with each other to define a plurality of pixel regions, wherein the thin film transistor is in each pixel region; the gate electrode of the thin film transistor is connected to the corresponding gate line, and the source electrode is connected to the corresponding data line; and the orthographic projection of the light-shielding member on the substrate does not overlap with an orthographic projection of the plurality of gate lines on the substrate.

In a third aspect, the present disclosure further provides a display apparatus, including the display substrate provided in the second aspect.

In a fourth aspect, the present disclosure further provides a method for manufacturing a thin film transistor, including: forming the source electrode, the buffer layer, the active layer, the drain electrode and the gate insulating layer on the substrate, respectively, wherein the drain electrode is connected to the active layer, the gate insulating layer is located on a side of the active layer away from the substrate, and includes the hollowed-out portion therein; forming the adapter electrode on a side of the active layer away from the substrate, wherein one portion of the adapter electrode is electrically connected to the active layer through the hollowed-out portion and the other portion of the adapter electrode is electrically connected to the source electrode through the first via, wherein the first via at least extends through the active layer and the buffer layer, and an orthographic projection of the first via on the substrate overlaps with an orthographic projection of the hollowed-out portion on the substrate; and forming the gate electrode on a side of the gate insulating layer away from the substrate.

In some embodiments, the forming the gate insulating layer includes: forming a gate insulating material layer; and patterning the gate insulating material layer to form the gate insulating layer including the hollowed-out portion, wherein the hollowed-out portion is the second via extending through the gate insulating layer, the orthographic projection of the first via on the substrate is a first projection, and an orthographic projection of the second via on the substrate is a second projection; and wherein the first projection is within the second projection; or one part of the second projection is within the first projection, and the other part of the second projection is outside the first projection.

In some embodiments, the active layer includes: a first portion to be processed, a second portion to be processed, and a channel portion between the first portion to be processed and the second portion to be processed, and a part of the first portion to be processed is exposed by the second via; the method further includes: performing a conductive treatment on the part of the first portion to be processed, which is exposed by the second via, and performing a conductive treatment on the first portion to be processed and the second portion to be processed, wherein the second portion to be processed, which is subjected to the conductive treatment, is used as the drain electrode.

In some embodiments, the method further includes forming a light-shielding member which is formed synchronously with the source electrode.

### BRIEF DESCRIPTION OF DRAWINGS

The accompanying drawings, which are provided for further understanding of the present disclosure and constitute a part of this specification, are for explaining the present disclosure together with the embodiments of the present disclosure, but are not intended to limit the present disclosure. In the drawings:
FIG. 1A is a plan view of a thin film transistor provided in some embodiments of the present disclosure.
FIG. 1B is a plan view of a thin film transistor provided in further embodiments of the present disclosure.
FIG. 2A is a cross-sectional view taken along a line A-A' of FIG. 1A.
FIG. 2B is another cross-sectional view taken along a line A-A' of FIG. 1A.
FIG. 2C is a cross-sectional view taken along a line B-B' of FIG. 1B.
FIG. 2D is another cross-sectional view taken along a line B-B' of FIG. 1B.
FIG. 2E is another cross-sectional view taken along a line B-B' of FIG. 1B.
FIG. 2F is a further cross-sectional view taken along a line B-B' of FIG. 1B.
FIG. 3A is a schematic view illustrating positions of a first via, a second via, and an active layer provided in some embodiments of the present disclosure.
FIG. 3B is a schematic view illustrating positions of a first via, a second via, and an active layer provided in further embodiments of the present disclosure.
FIG. 3C is a schematic view illustrating positions of a first via, a second via, and an active layer provided in further embodiments of the present disclosure.
FIG. 3D is a schematic view illustrating positions of a first via, a second via, and an active layer provided in further embodiments of the present disclosure.
FIG. 3E is a schematic view illustrating positions of a first via, a second via, and an active layer provided in further embodiments of the present disclosure.
FIG. 4A is a scanning electron microscope (SEM) image of a longitudinal cross-section of a first via provided in some embodiments of the present disclosure.
FIG. 4B is a scanning electron microscope (SEM) image of a longitudinal cross-section of a first via and its periphery provided in some embodiments of the present disclosure.
FIG. 5 is a plan view of a display substrate provided in some embodiments of the present disclosure.
FIG. 6A is a cross-sectional view of a display substrate provided in some embodiments of the present disclosure.
FIG. 6B is a cross-sectional view of a display substrate provided in further embodiments of the present disclosure.
FIG. 7A is a schematic view illustrating connection between a thin film transistor and a gate line as well as between the thin film transistor and a data line provided in some embodiments of the present disclosure.
FIG. 7B is a schematic view illustrating connection between a thin film transistor and a gate line as well as between the thin film transistor and a data line provided in some embodiments of the present disclosure.
FIGS. 8A to 8H are schematic diagrams illustrating a method for manufacturing a thin film transistor provided in a first example of the present disclosure.
FIG. 9A is a schematic diagram illustrating a method for manufacturing a thin film transistor provided in a third example of the present disclosure.
FIG. 9B is a schematic diagram illustrating a method for forming a second via in a gate insulating layer in step S41 of FIG. 9A.
FIG. 10 is a schematic diagram illustrating a method for manufacturing a thin film transistor provided in a fourth example of the present disclosure.
FIG. 11 is a schematic diagram illustrating a method for manufacturing a thin film transistor provided in a fifth example of the present disclosure.
FIG. 12 is a schematic diagram illustrating a method for manufacturing a thin film transistor provided in a sixth example of the present disclosure.
FIG. 13 is a schematic diagram illustrating a method for manufacturing a thin film transistor provided in a seventh example of the present disclosure.

### DETAIL DESCRIPTION OF EMBODIMENTS

The embodiments of the present disclosure will be described in detail below with reference to the accompanying drawings. The embodiments of the present disclosure described here are only for illustrating and explaining the present disclosure, but are not intended to limit the present disclosure.

To make the objects, technical solutions and advantages of the embodiments of the present disclosure more apparent, the technical solutions of the embodiments of the present disclosure will be clearly and completely described below with reference to the drawings of the embodiments of the present disclosure. It is to be understood that the described embodiments are only a few, not all of, embodiments of the present disclosure. All other embodiments, which could be derived by a person skilled in the art from the described embodiments of the present disclosure without any creative effort, are within the protection scope of the present disclosure.

The terms used herein to describe embodiments of the present disclosure are not intended to limit and/or define the protection scope of the present disclosure. For example, unless otherwise defined, technical or scientific terms used in the present disclosure shall have the ordinary meaning as understood by one of ordinary skill in the art to which the present disclosure belongs. It should be understood that the terms "first", "second", and the like used in the present disclosure are not intended to indicate any order, quantity, or importance, but rather are used for distinguishing one element from another. Unless the context clearly dictates otherwise, the singular form "a", "an", "the", or the like does not denote a limitation of quantity, but rather denotes the presence of at least one element. The term "comprising", "including", or the like means that the element or item preceding the term "comprising", "including" contains the element or item listed after the term "comprising", "including" and its equivalent, but does not exclude other elements or items. The term "connected", "coupled", or the like is not limited to physical or mechanical connections, but may include electrical connections, whether direct or indirect connections. The terms "upper", "lower", "left", "right", and the like are used only for indicating relative positional relationships, and when the absolute position of an object being described is changed, the relative positional relationships may also be changed accordingly.

Conductive structures in different layers are required to be electrically connected to each other through vias in a display substrate. The vias are formed through a patterning process. An area occupied by the whole thin film transistor is great due to the vias with a great area, which affects a resolution, a frame size, a transmittance and the like of a product.

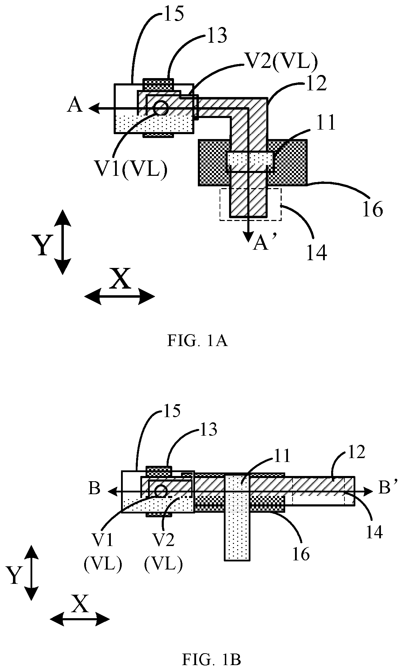

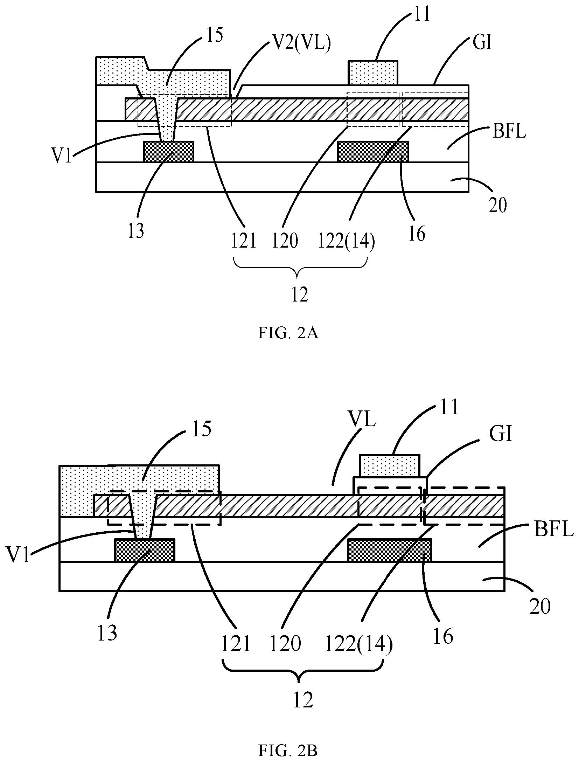

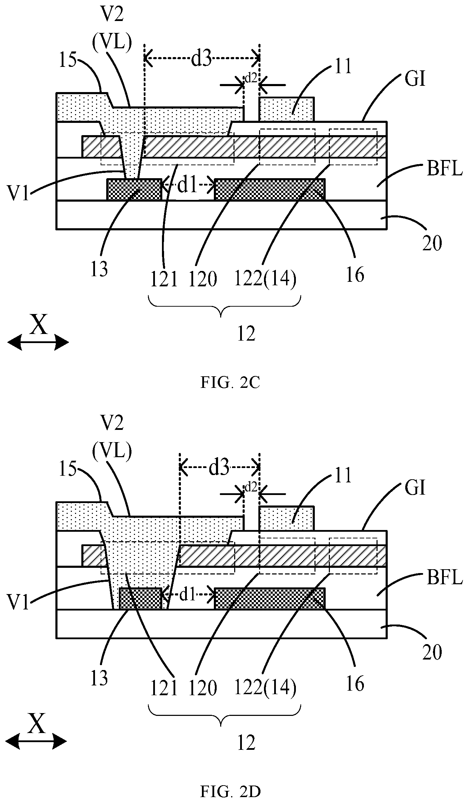

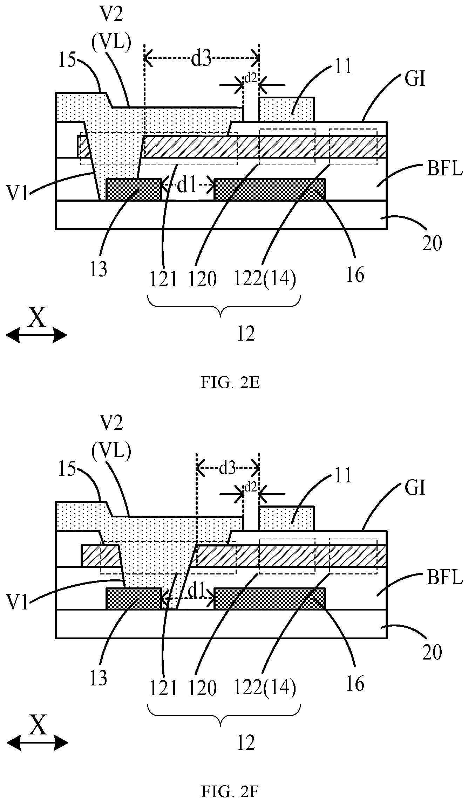

FIG. 1A is a plan view of a thin film transistor provided in some embodiments of the present disclosure. FIG. 1B is a plan view of a thin film transistor provided in further embodiments of the present disclosure. FIG. 2A is a cross-sectional view taken along a line A-A' of FIG. 1A. FIG. 2B is another cross-sectional view taken along a line A-A' of FIG. 1A. FIG. 2C is a cross-sectional view taken along a line B-B' of FIG. 1B. FIG. 2D is another cross-sectional view taken along a line B-B' of FIG. 1B. FIG. 2E is another cross-sectional view taken along a line B-B' of FIG. 1B. FIG. 2F is a further cross-sectional view taken along a line B-B' of FIG. 1B.

As shown in FIGS. 1A to 2F, a thin film transistor 10 includes: a gate electrode 11, an active layer 12, a source electrode 13 and a drain electrode 14 on the substrate 20, wherein the active layer 12 is arranged on a side of the source electrode 13 away from the substrate 20, the gate electrode 11 is arranged on a side of the active layer 12 away from the substrate 20, and the source electrode 13 and the drain electrode 14 are connected to the active layer 12.

In addition, as shown in FIGS. 2A to 2F, the thin film transistor 10 further includes: a buffer layer BFL, a gate insulating layer GI, and an adapter electrode 15, the buffer layer BFL is disposed on the substrate 20 between the active layer 12 and the source electrode 13. The buffer layer BFL may be used to avoid or mitigate diffusion of metal atoms and/or impurities from the substrate 20 into the active layer 12. The buffer layer BFL may be made of one or more of silicon nitride, silicon oxide, and silicon oxynitride. A thickness of the buffer layer BFL is in a range from 100 nm to 700 nm.

The gate insulating layer GI is disposed between layers where the active layer 12 and the gate electrode 11 are located, and has a hollowed-out portion VL therein, and the hollowed-out portion VL may be a via or a hollowed-out portion between the gate insulating layers GI of any two adjacent thin film transistors 10. The gate insulating layer GI may be made of an inorganic material such as silicon oxide, silicon nitride, and/or silicon oxynitride, and may include multiple layers or a single layer.

The adapter electrode 15 is located on a side of the active layer 12 away from the substrate 20, is electrically connected to the active layer 12 and is electrically connected to the source electrode 13 through a first via V1. The first via V1 at least extends through the active layer 12 and the buffer layer BFL, an orthographic projection of the first via V1 on the substrate 20 overlaps with an orthographic projection of the hollowed-out portion on the substrate 20. For example, the gate insulating layers GI of the adjacent thin film transistors 10 are connected together and have a one-piece structure, as shown in FIGS. 2A and 2C to 2F, which has the second via V2 therein, and an orthographic projection of the second via V2 on the substrate 20 and the orthographic projection of the first via V1 on the substrate 20 overlap with each other. Alternatively, as shown in FIG. 2B, the gate insulating layers GI of different thin film transistors 10 are independent from each other and are formed as block-shaped layers, and the hollowed-out portion around each block-shaped layer overlaps with the orthographic projection of the first via V1 on the substrate 20.

In some embodiments, the active layer 12 is made of a metal oxide, such as IGZO (indium gallium zinc oxide), IGTO, IGZTO (indium gallium zinc tin oxide), IGZYO, or ITZO (indium tin zinc oxide). The adapter electrode 15 and the source electrode 13 may be made of a metal material. When the active layer 12 is made of a metal oxide, if the active layer 12 is directly connected to the source electrode 13 through a via, an oxide is easily generated at a contact interface between the active layer 12 and the source electrode 13, thereby increasing a contact resistance between the active layer 12 and the source electrode 13. In the embodiment of the present disclosure, the adapter electrode 15 is adopted, is located on a side of the active layer 12 away from the substrate 20 and is electrically connected to the active layer 12 and the source electrode 13. In this case, in the manufacturing process, after the active layer 12 is formed, a surface of the active layer 12 corresponding to the adapter electrode 15 may be processed to prevent the oxide from being generated at the interface between the active layer 12 and the adapter electrode 15, so as to reduce the contact resistance between the active layer 12 and the adapter electrode 15, and further ensure the connection reliability between the active layer 12 and the source electrode 13. In addition, in the embodiment of the present disclosure, the orthographic projection of the first via V1 on the substrate 20 overlaps with the orthographic projection of the hollowed-out portion VL of the gate insulating layer GI on the substrate 20, so that an area occupied by the hollowed-out portion VL and the first via V1 as a whole can be reduced, which is favorable for improving the resolution, reducing a frame width, increasing the light transmittance, and the like.

In some embodiments, as shown in FIGS. 2C to 2F, an orthographic projection of the adapter electrode 15 on the substrate 20 covers the orthographic projection of the second via V2 on the substrate 20.

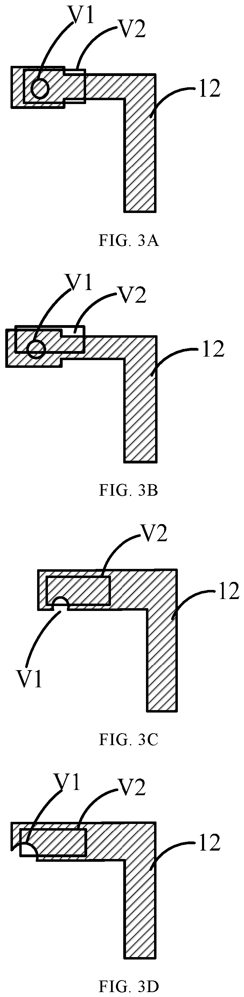

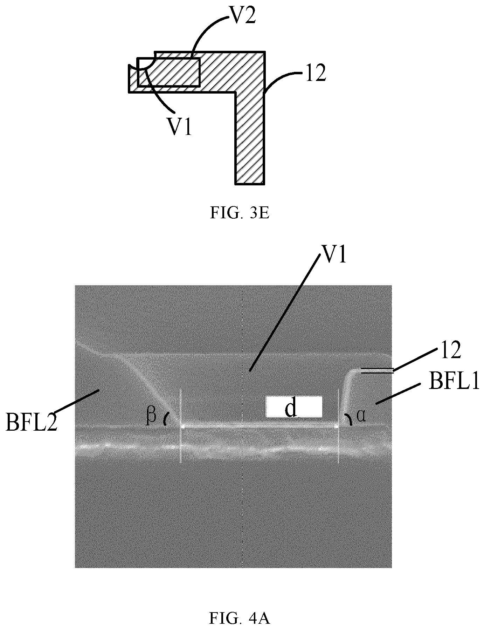

In some embodiments, the first via V1 extends through the gate insulating layer GI, the active layer 12, and the buffer layer BFL. The hollowed-out portion is the second via V2 extending through the gate insulating layer GI. FIG. 3A is a schematic diagram of positions of a first via, a second via, and an active layer provided in some embodiments of the present disclosure. FIG. 3B is a schematic diagram of positions of a first via, a second via, and an active layer provided in further embodiments of the present disclosure. FIG. 3C is a schematic diagram of positions of a first via, a second via, and an active layer provided in further embodiments of the present disclosure. FIG. 3D is a schematic diagram of positions of a first via, a second via, and an active layer provided in further embodiments of the present disclosure. FIG. 3E is a schematic diagram of positions of a first via, a second via, and an active layer provided in further embodiments of the present disclosure. As shown in FIGS. 3A to 3E, the orthographic projection of the first via V1 on the substrate 20 is a first projection, the orthographic projection of the second via V2 on the substrate 20 is a second projection, and the first projection and the second projection overlap with each other. As shown in FIG. 3A, the first projection is located within the second projection. Alternatively, as shown in FIGS. 3B to 3E, one part of the second projection is located within the first projection, and the other part of the second projection is located outside the first projection. In addition, as shown in FIGS. 3A and 3B, the first projection may be located within an orthographic projection of the active layer 12 on the substrate 20 and be spaced apart from a boundary of the orthographic projection of the active layer 12 on the substrate 10. Alternatively, as shown in FIGS. 3C to 3E, the first projection may be located at a corner of the orthographic projection of the active layer 12 on the substrate 20.

Shapes of the first via V1 and the second via V2 are not particularly limited in the embodiments of the present disclosure. For example, the orthographic projection of the first via V1 on the substrate 20 may be circular, rectangular, semicircular, or other irregular shape. In addition, the orthographic projection of the first via V1 on the substrate 20 may be within the orthographic projection of the active layer 12 on the substrate 20, or beyond the orthographic projection of the active layer 12 on the substrate 20.

In some embodiments, as shown in FIGS. 1A and 1B, the adapter electrode 15 and the gate electrode 11 are disposed in the same layer. It should be noted that "in the same layer" in the embodiment of the present disclosure means that two structures are formed by the same material layer through a patterning process, and therefore, are located in the same layer in a stacking relationship, but this does not mean that a distance between the adapter electrode 15 and the substrate 20 is certainly the same as a distance between the gate electrode 11 and the substrate 20.

In some embodiments, as shown in FIGS. 1A to 2F, the thin film transistor 10 further includes a light-shielding member 16 located between the active layer 12 and the substrate 20, and an orthographic projection of the light-shielding member 16 on the substrate 20 at least partially overlaps with an orthographic projection of the active layer 12 on the substrate 20. For example, the active layer 12 includes a first conductive portion 121, a second conductive portion 122, and a channel portion 120 therebetween, and the orthographic projection of the light-shielding member 16 on the substrate 20 at least covers an orthographic projection of the channel portion 120 on the substrate 20. The light-shielding member 16 may avoid a large amount of leakage current generated at the channel portion 120 of the active layer 12 due to light irradiation, thereby preventing the characteristics of the thin film transistor 10 from being affected.

As shown in FIGS. 1A and 1B, the adapter electrode 15 is connected to the first conductive portion 121 of the active layer 12 through the second via V2, and is connected to the source electrode 13 through the first via V1.

In the manufacturing process, if the second via V2 is formed by directly patterning the gate insulating layer GI, the active layer 12 below the second via V2 may be dry-etched very likely in the etching process due to a small thickness of the active layer 12, which may damage the active layer 12 and further damage the buffer layer BFL below the active layer 12. At this time, if a distance between the light-shielding member 16 and the source electrode 13 is small, the first via V1/the second via V2 may extend to the light-shielding member 16, and after the adapter electrode 15 is formed in the via, a short circuit may occur between the adapter electrode 15/the source electrode 13 and the light-shielding member 16.

In order to avoid damage to the active layer 12 when the second via V2 is formed and to avoid the short circuit occurring between the light-shielding member and the adapter electrode/the drain electrode caused by the via extending to the light-shielding member, the light-shielding member 16 is located away from the second via V2 as much as possible.

As shown in FIG. 1A, the light-shielding member 16 and the second via V2 are staggered, that is, the orthographic projection of the light-shielding member 16 on the substrate 20 does not overlap with the orthographic projection of the second via V2 on the substrate 20. Based on this, when the adapter electrode 15 is provided in the second via V2, the adapter electrode 15 does not overlap with the light-shielding member 16 in a direction perpendicular to the substrate. In addition, in the thin film transistor according to the embodiment of the present disclosure, the gate insulating layer GI is patterned by using a halftone mask process to form the second via V2, so as to avoid damage to the active layer 12. Therefore, in the thin film transistor shown in FIG. 1A, the light-shielding member and the second via are staggered, and the second via is formed by adopting the halftone mask process, so that poor products are avoided.

In some embodiments, the orthographic projection of the light-shielding member 16 on the substrate 20 partially overlaps with the orthographic projection of the second via V2 on the substrate 20. The orthographic projection of the light-shielding member 16 on the substrate 20 partially overlaps with the orthographic projection of the adapter electrode 15 on the substrate 20.

The second via is formed by using the halftone mask process (the specific manufacturing method is described in the following embodiments and is not described here) in the thin film transistor in the embodiment of the present disclosure, so that the active layer 12 may not be damaged, and therefore the buffer layer BLF on a side of the active layer 12 close to the substrate 20 may not be damaged even if the thickness of the active layer 12 is small. In view of this, the orthographic projection of the light-shielding member 16 on the substrate 20 partially overlaps with the orthographic projection of the second via V2 on the substrate 20 only in the thickness direction of the substrate 20, as shown in FIG. 2C, the light-shielding member 16 and the second via V2 are separated from each other by the active layer 12 and the buffer layer BFL therebetween, and the adapter electrode 15 formed in the second via V2 and the light-shielding member 16 are insulated and separated from each other, so that the short-circuit phenomenon can be avoided.

In some embodiments, as shown in FIG. 2C, a portion of the adapter electrode 15 connected to the active layer through the hollowed-out portion/the second via V2 and a portion of the adapter electrode 15 connected to the source electrode through the first via V1 are arranged along a first direction X. That is, as shown in FIGS. 3A to 3E, the first via V1 is located on a side of the hollowed-out portion/the second via V2 away from the gate electrode 11/the light-shielding member 16 in the first direction, so as to further avoid the risk of short circuit caused by the contact of the adapter electrode 15 with the light-shielding member 16 through the first via V1.

It should be understood that the connection between the adapter electrode 15 in the first via V1 and the source electrode 13 may be flexibly set. As shown in FIG. 2D, the adapter electrode 15 and the source electrode 13 may be electrically connected to each other in a full-coverage manner (that is, the adapter electrode 15 fully covers the source electrode 13). As shown in FIGS. 2E to 2F, the adapter electrode 15 and the source electrode 13 may be electrically connected to each other in a partial lap joint manner (that is, the adapter electrode 15 partially covers the source electrode 13), which is not limited in the embodiment of the present disclosure.

In some embodiments, the adapter electrode 15 may be formed only in a partial region of the second via V2, or may completely fill the second via V2. As shown in FIG. 2A, the orthographic projection of the adapter electrode 15 on the substrate 20 partially overlaps with the orthographic projection of the second via V2 on the substrate 20. Preferably, as shown in FIGS. 2C to 2F, the orthographic projection of the adapter electrode 15 on the substrate 20 covers the orthographic projection of the second via V2 on the substrate 20.

In some embodiments, as shown in FIGS. 1A to 2F, the light-shielding member 16 and the source electrode 13 are disposed in the same layer. In one example, the light-shielding member 16 and the source electrode 13 may each employ a Mo/Al/Al metal laminated structure, a MoNb/Cu metal laminated structure, an MTD/Cu metal laminated structure, or a MoNb/Cu/MTD metal laminated structure. Thicknesses of the light-shielding member 16 and the source electrode 13 may be in a range from 1000Å to 10000Å.

In some embodiments, as shown in FIGS. 1B and 2C to 2F, the light-shielding member 16 and the source electrode 13 are arranged along the first direction X, and a distance d1 between the light-shielding member 16 and the source electrode 13 in the first direction X is in a range from 1µm to 3µm, such as 1µm, 1.5µm, 2µm, 2.5µm, 3µm, or the like, which is not limited in the embodiments of the present disclosure.

In some embodiments, as shown in FIG. 1B and FIG. 2C to FIG. 2F, the adapter electrode 15 and the gate electrode 11 are disposed in the same layer, and are arranged along the first direction X, and a distance d2 between the adapter electrode 15 and the gate electrode 11 in the first direction X is in a range from 1µm to 3µm, such as 1µm, 1.5µm, 2µm, 2.5µm, 3µm, or the like, which is not limited in the embodiments of the present disclosure.

In the thin film transistor provided in the embodiment of the present disclosure, the active layer below the second via V2 is not damaged in the process of forming the second via V2, and an aperture of the first via V1 is smaller than that of the second via V2, so that the via extending through the gate insulating layer GI, the active layer 12, and the buffer layer BFL does not extend to the light-shielding member 16. Further, the distance between the light-shielding member 16 and the source electrode 13 may be set to be small, and correspondingly, a distance between the adapter electrode 15 connected to the source electrode 13 and the gate electrode 11 opposite to the channel portion 120 shielded by the light-shielding member 16 may be set to be small. Therefore, an area occupied by the whole thin film transistor can be reduced, the resolution is improved, the frame width is reduced, the light transmittance is increased and the like.

In some embodiments, the first conductive portion 121 and the second conductive portion 122 of the active layer 12 are formed by doping a semiconductor material. The first via V1 extends through the first conductive portion 121, and the second conductive portion 122 serves as the drain electrode 14.

As shown in FIG. 1A, the light-shielding member 16 and the adapter electrode 15 are staggered, and the adapter electrode 15 extends through the first conductive portion 121 of the active layer 12, and the light-shielding member 16 and the channel portion 120 of the active layer are opposite to each other, that is, the first conductive portion 121 and the channel portion 120 of the active layer are also staggered, so that the active layer pattern in FIG. 1A is L-shaped.

It should be understood that a first active wire is formed between a portion of the active layer 12 connected to the source electrode 13 through the adapter electrode 15 and the channel portion 120, and a second active wire is formed between a portion (i.e., the second conductive portion 122) of the active layer 12 serving as the drain electrode 14 and the channel portion 120, so that the source electrode 13 and the drain electrode 14 are electrically connected to each other when a carrier path is formed in the channel portion 120 of the active layer 12.

Further, as shown in FIG. 1A, the source electrode 13 of the thin film transistor is connected to a corresponding data line, the adapter electrode 15 is connected to the source electrode 13 through the second via V2/the first via V1, the second via V2 does not overlap with the light-shielding member 16 in the direction perpendicular to the substrate 20, and the light-shielding member 16 is directly opposite to the channel portion 120 in the active layer 12, so that the first active wire connecting the source electrode 13 and the channel portion 120 is L-shaped. In addition, since the source electrode 13 is connected to the data line, the first active conductive wire is also electrically connected to the data line. If the first active conductive line is too long, the load loss on the data line is increased.

Based on this, as shown in FIG. 1B, FIG. 2C to FIG. 2F, the channel portion 120 and the second conductive portion 122 of the active layer are arranged along the first direction X, and the first conductive portion 121 is strip-shaped and extends along the first direction X.

In some embodiments, as shown in FIG. 1B and FIG. 2C to FIG. 2F, an orthographic projection of a portion of the first conductive portion 121 in contact with the adapter electrode 15 on the substrate 20 and an orthographic projection of the channel portion 120 on the substrate 20 have a distance d3 in a range from 1µm and 4µm in the first direction X, that is, a length of the first active wire is in a range from 1µm to 4µm, such as 1µm, 1.5µm, 2µm, 2.5µm, 3µm, 3.5µm, 4µm, or the like, which is not limited in the embodiments of the present disclosure.

That is, the light-shielding member 16 and the source electrode 13 are arranged along the first direction X, and a distance between the light-shielding member 16 and the source electrode 13 is reduced, and correspondingly, the first conductive portion 121 and the channel portion 120 in the active layer 12 are also arranged along the first direction X, and the first conductive portion 121 is strip-shaped. Furthermore, the length of the first active wire is less than or equal to 4µm, which is favorable for reducing the load loss on the data line and the area occupied by the whole thin film transistor, thereby improving the resolution.

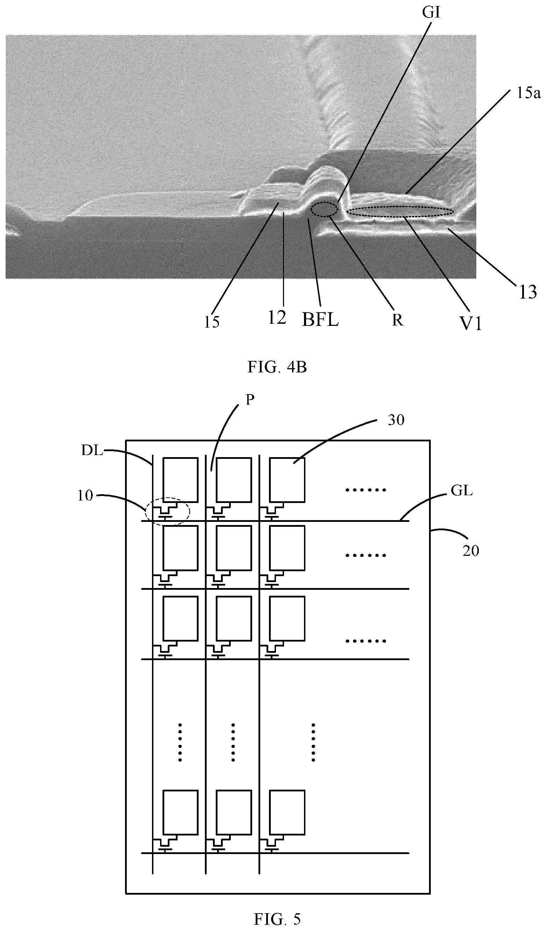

FIG. 4A is a scanning electron microscope (SEM) image of a longitudinal cross-section of a first via provided in some embodiments of the present disclosure. FIG. 4B is a scanning electron microscope (SEM) image of a longitudinal cross-section of a first via and its periphery provided in some embodiments of the present disclosure. In FIGS. 4A and 4B, the orthographic projection of the first via V1 on the substrate 20 is located outside the orthographic projection of the active layer 12 on the substrate 20, as shown in FIG. 4, the buffer layer BFL includes a first portion BFL1 covered by the active layer 12 and a second portion BFL2 not in contact with the active layer 12, the first portion has a first slope surface close to the first via V1 and having a slope angle α in a range from 70° to 90°, and the second portion BFL2 has a second slope surface close to the first via V1 and having a slope angle β less than or equal to 60°. When the first via V1 is etched, an upper portion of the second portion BFL2 is covered by a photoresist, and an upper portion of the first portion BFL1 is covered by the active layer 12, so that a topography of the finally formed first via V1 may have the different slope angles. An aperture d of the first via V1 at an end of the first via V1 close to the substrate 20 is smaller than 2µm. For example, the aperture d is in a range from 1.6µm to 1.8µm. For example, the aperture d is 1.65µm.

In some embodiments, an orthographic projection of a bottom of the first via V1 on the substrate is located within an area covered by the orthographic projection of the source electrode on the substrate, and a difference between a length of the source electrode in the first direction and a length of the bottom of the first via V1 in the first direction is greater than or equal to 0.5µm.

In some embodiments, the buffer layer BFL is formed with a protrusion portion R covering a portion of the source electrode close to the channel portion of the active layer 12.

In some embodiments, a thickness of the protrusion portion R in the direction perpendicular to the substrate is in a range from 1000µm to 20000µm.

In some embodiments, a surface of the protrusion portion R away from the substrate is an arc surface having a radian in a range from 15° to 90°.

In some embodiments, a portion of the adapter electrode 15 located within the first via V1 is a third portion 15a, a surface of the third portion 15a away from the substrate is a convex surface protruding away from the substrate. A portion of the third portion 15a close to an edge of the first via is relatively thin, and a portion of the third portion 15a close to a center of the first via is relatively thick.

In some embodiments, a difference between the maximum thickness and the minimum thickness of the third portion 15a in the direction perpendicular to the substrate is in a range from 0.3µm to 0.6µm, preferably in a range from 0.35µm to 0.55µm.

In some embodiments, the hollowed-out portion is the second via V2 extending through the gate insulating layer GI, a difference between a slope angle of a slope surface of the gate insulating layer GI close to the second via V2 and a slope angle of a slope surface of the active layer 12 close to the first via V1 is greater than or equal to 0° and less than or equal to 30°, the slope surface of the gate insulating layer GI and the slope surface of the active layer 12 are on the same side. For example, the difference is in a range from 2° to 10°.

As an example, the slope angle of the slope surface of the gate insulating layer GI close to the second via V2 is in a range from 30° to 90°. The slope angle of the slope surface of the active layer 12 close to the first via V1 on the same side as the slope surface of the gate insulating layer GI is in a range from 30° to 90°.

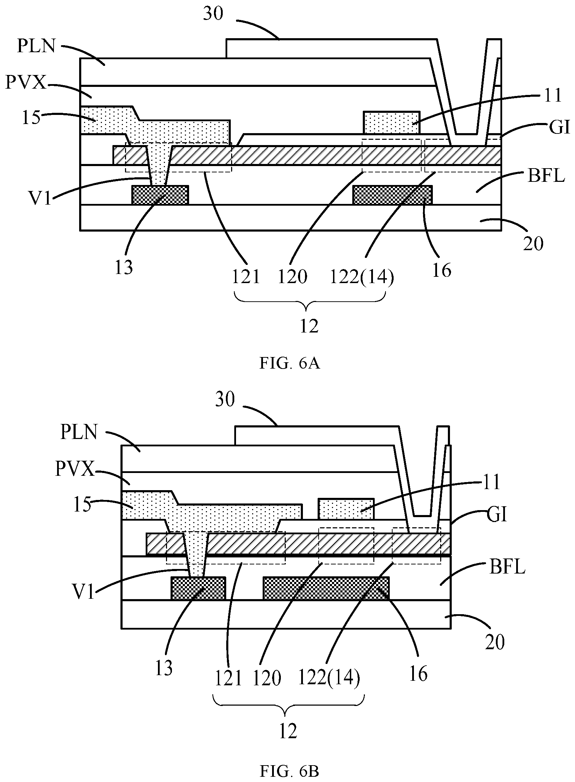

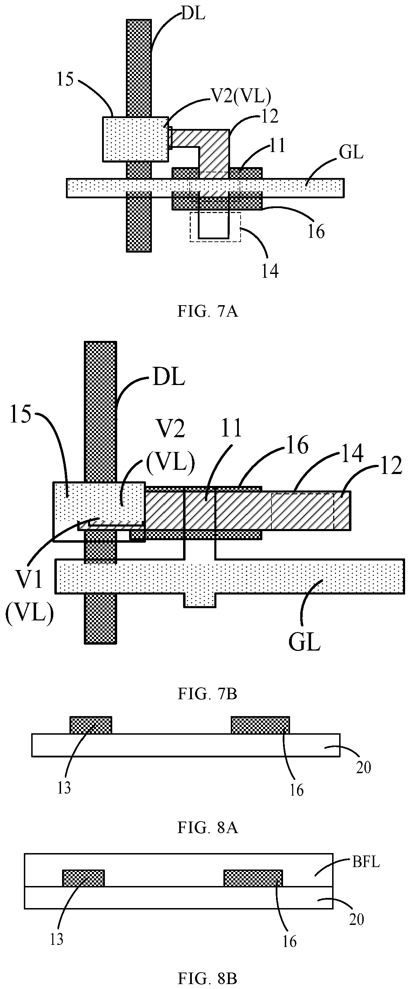

Embodiments of the present disclosure further provide a display substrate. FIG. 5 is a plan view of a display substrate provided in some embodiments of the present disclosure. FIG. 6A is a cross-sectional view of a display substrate provided in some embodiments of the present disclosure. FIG. 6B is a cross-sectional view of a display substrate provided in further embodiments of the present disclosure. FIG. 7A is a schematic diagram of a connection of a thin film transistor, a gate line and a data line provided in some embodiments of the present disclosure. FIG. 7B is a schematic diagram of a connection of a thin film transistor, a gate line and a data line provided in some embodiments of the present disclosure. As shown in FIG. 5 to FIG. 7B, the display substrate includes the thin film transistor 10 in the embodiments described above.

In one example, the display substrate may be used in a liquid crystal display panel, and include: a plurality of gate lines GL extending in the first direction X and a plurality of data lines DL extending in a second direction Y on the substrate 20, which intersect with each other to define a plurality of pixel regions P, each pixel region is provided with the thin film transistor 10 in the above embodiments. The gate electrode 11 of the thin film transistor 10 is connected to the corresponding gate line GL, the source electrode 13 is connected to the corresponding data line DL, and the drain electrode 14 is connected to the pixel electrode 30 in the pixel region P where the thin film transistor 10 is located. In some embodiments, as shown in FIGS. 6A and 7A, the gate electrode 11 of the thin film transistor 10 and the corresponding gate line GL have a one-piece structure, and extend along the same direction, and the source electrode 13 of the thin film transistor 10 and the corresponding data line DL have a one-piece structure.

In other embodiments, as shown in FIGS. 6B and 7B, the gate electrode 11 of the thin film transistor 10 and the corresponding gate line GL have a one-piece structure, and the gate line GL extends along the first direction X, and the gate electrode 11 is a strip-shaped electrode extending along the second direction Y, and the orthographic projection of the light-shielding member 16 on the substrate 20 does not overlap with the orthographic projection of the corresponding gate line GL on the substrate 20.

In some embodiments, as shown in FIGS. 6B and 7B, the light-shielding member 16 and the source electrode 13 are disposed along the first direction X with a reduced distance therebetween, and correspondingly, the gate electrode 11 and the adapter electrode 15 are disposed along the first direction X with a reduced distance therebetween. The reduction of the length of the active layer 12 is favorable for reducing the load loss of the data line. In the embodiment of the present disclosure, the area occupied by the whole thin film transistor on the display substrate is reduced, which is favorable for improving the resolution, reducing the frame width, increasing the light transmittance, and the like.

In some embodiments, a passivation layer PVX and a planarization layer PLN are further disposed on a side of the gate electrode 11 of the thin film transistor 10 away from the substrate 20, the planarization layer PLN is disposed on a side of the passivation layer PVX away from the substrate 20, the passivation layer PVX may be made of one or more of silicon oxide, silicon nitride, and silicon oxynitride, and may have a thickness in a range from 200 nm and 400 nm. The planarization layer PLN may have a thickness in a range from 2µm to 3µm, and be made of the organic material. The pixel electrode 30 is located on a side of the planarization layer PLN away from the substrate 20 and is connected to the drain electrode 14 through a third via V3 extending through at least the planarization layer PLN and the passivation layer PVX. The pixel electrode 30 may be made of transparent conductive material such as IGZO or IZO, and may have a thickness in a range from 400Å to 1000Å.

In some embodiments, the display substrate further includes: an insulating spacer layer (not shown) and a common electrode (not shown), wherein the insulating spacer layer is located on a side of the pixel electrode 30 away from the substrate 20, may be made of at least one of silicon nitride, silicon oxide and silicon oxynitride, and may have a thickness in a range from 1000Å to 3000Å. The common electrode is located on a side of the insulating spacer layer away from the substrate 20, may be made of a transparent conductive material such as ITO, IZO, or the like, and may have a thickness of 40nm or 135 nm.

The embodiment of the present disclosure further provides a display apparatus, which includes the display substrate in the above embodiments. The display apparatus may be a product or a component with a display function, such as a mobile phone, a tablet computer, a navigator, electronic paper, an OLED panel or the like.

The embodiment of the present disclosure further provides a method for manufacturing the thin film transistor, including steps S11 to S13:

The step S11 includes forming a source electrode, a buffer layer, an active layer, a drain electrode and a gate insulating layer on a substrate, respectively. The source electrode and the drain electrode are electrically connected to the active layer.

The step S12 includes forming an adapter electrode, wherein the adapter electrode is located on a side of the active layer away from the substrate, is electrically connected to the active layer and is electrically connected to the source electrode through a first via at least extending through the active layer and the buffer layer; wherein at least a portion of the first via is exposed by the gate insulating layer.

The step S13 includes forming a gate electrode on a side of the gate insulating layer away from the substrate.

In some embodiments, the forming the gate insulating layer includes: forming a gate insulating material layer, and then, patterning the gate insulating material layer to form the gate insulating layer. The gate insulating layer has a second via through which the adapter electrode is connected to the active layer, an orthographic projection of the first via on the substrate is a first projection, an orthographic projection of the second via on the substrate is a second projection, and the second projection is located in the first projection. Alternatively, one part of the second projection is located within the first projection, and the other part of the second projection is located outside the first projection.

In some embodiments, the active layer includes: a first portion to be processed, a second portion to be processed and a channel portion located therebetween, a part of the first portion to be processed is exposed by the second via. The manufacturing method further includes: performing a conductive treatment on the part of the first portion to be processed, which is exposed by the second via, and performing a conductive treatment on the first portion to be processed and the second portion to be processed, wherein the second portion to be processed, which is subjected to the conductive treatment, is used as a drain electrode.

In some embodiments, the method further includes: forming a light-shielding member. The light-shielding member is formed synchronously with the source electrode.

FIGS. 8A to 8H are schematic diagrams illustrating a method for manufacturing a thin film transistor provided in a first example of the present disclosure. As shown in FIGS. 8A to 8H, a method for manufacturing a thin film transistor 10 includes steps S20 to S29.

The step S20 includes providing a substrate 20, and cleaning the substrate 20.

The step S21 includes forming a source electrode 13 and a light-shielding member 16, as shown in FIG. 8A. The source electrode 13 and the light-shielding member 16 may each employ a Mo/Al/Al metal laminated structure, a MoNb/Cu metal laminated structure, or an MTD/Cu metal laminated structure. Thicknesses of the light-shielding member 16 and the source electrode 13 may be in a range from 1000Å to 10000Å.

The step S22 includes forming a buffer layer BFL, as shown in FIG. 8B, wherein the buffer layer BFL may be formed by using a chemical vapor deposition (CVD) process, and may be made of one or more of silicon nitride, silicon oxide, and silicon oxynitride. A thickness of the buffer layer BFL is in a range from 100 nm to 700 nm.

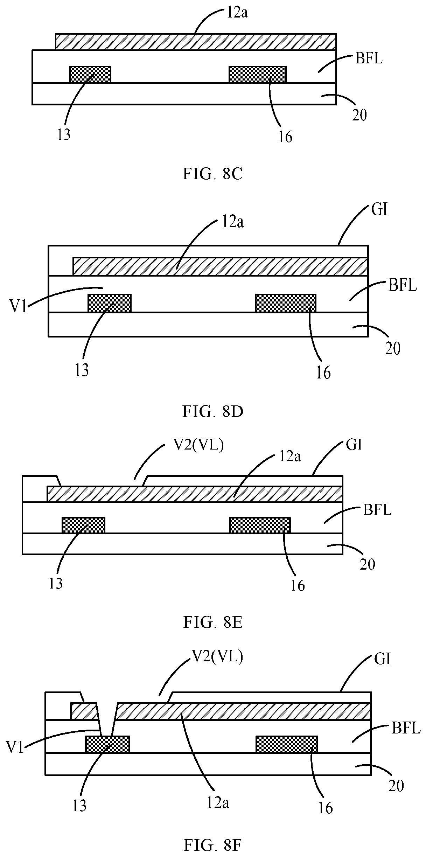

The step S23 includes forming a semiconductor layer 12a, as shown in FIG. 8C, wherein the semiconductor layer 12a may be formed by a sputtering process, and may be made of IGZO, and has a thickness in a range from 10 nm to 80 nm.

The step S24 includes forming a gate insulating layer GI, as shown in FIG. 8D, and the gate insulating layer GI may be formed by a CVD process or an atomic layer deposition (ALD) process. The gate insulating layer GI may be made of one or more of silicon nitride, silicon oxide and silicon oxynitride, and has a thickness in a range from 600 Å to 2000 Å.

The step S25 includes patterning the gate insulating layer GI, as shown in FIG. 8E, to form a second via V2 extending through the gate insulating layer GI, and the semiconductor layer 12a is exposed by the second via V2.

The step S26 includes performing a conductive treatment on the semiconductor layer 12a, so that a part of the semiconductor layer 12a exposed by the second via V2 is formed as a conductor.

The step S27 includes forming a first via V1, as shown in FIG. 8F, the first via V1 extends through at least the semiconductor layer 12a and the buffer layer BFL and exposes at least a portion of the source electrode 13.

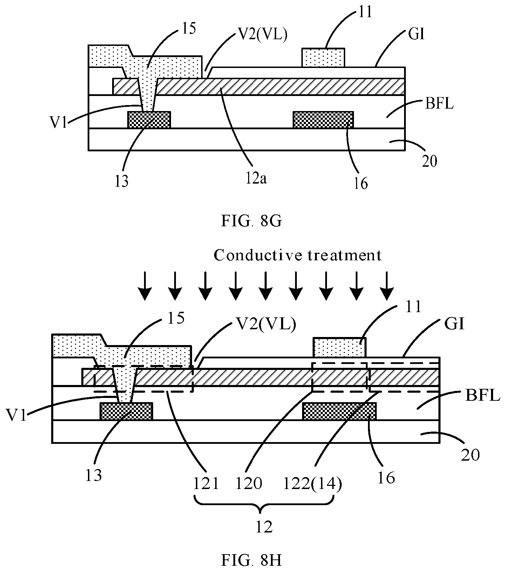

The step S28 includes forming a MoNb/Cu laminated structure, an MTD/Cu laminated structure, or a MoNb/Cu/MTD laminated structure with a thickness in a range from 200 nm to 1200 nm, as shown in FIG. 8G, patterning the laminated structure to form the adapter electrode 15 and the gate electrode 11, wherein the adapter electrode 15 is connected to the semiconductor layer 12a through the second via V2, and is connected to the source electrode 13 through the first via V1.

The step S29 includes performing a conductive treatment on the semiconductor layer 12a to form an active layer 12, as shown in FIG. 8H, the active layer 12 includes a first conductive portion 121 and a second conductive portion 122, and a channel portion 120 therebetween, the first conductive portion 121 is connected to the adapter electrode 15, and the second conductive portion 122 serves as the drain electrode 14.

In a second example, after the steps S20 to S29, the method for manufacturing a thin film transistor 10 further includes: S30 of etching the gate insulating layer GI, wherein the etched gate insulating layer GI is not in contact with the adapter electrode 15, and an orthographic projection of the gate insulating layer GI on the substrate 20 may coincide with or slightly exceed an orthographic projection of the gate electrode 11 on the substrate 20.

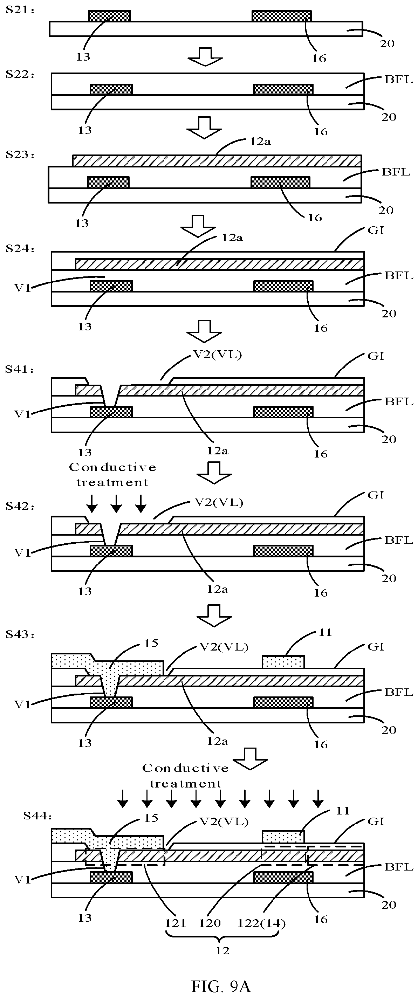

FIG. 9A is a schematic diagram illustrating a method for manufacturing a thin film transistor provided in a third example of the present disclosure. As shown in FIG. 9A, a method for manufacturing a thin film transistor 10 includes: the steps S20 to S24 and steps S41 to S44.

The step S41 includes synchronously forming a first via V1 and a second via V2. Specifically, a photoresist layer is first formed on the gate insulating layer GI, and is then exposed and developed by using a halftone mask, to remove the photoresist in the first region, and a part of the photoresist in the second region, and maintain the photoresist in the third region. The first region is a region corresponding to the first via V1, the second region is a region except for the region corresponding to the first via V1 in a region where the second via V2 is located, and the third region is a region except for the first region and the second region. Then, a first etching process is performed to form the first via V1, an ashing process is performed on the photoresist layer to remove the photoresist in the second region, and a second etching process is then performed to form the second via V2 extending through the gate insulating layer GI.

The step S42 includes performing a conductive treatment on the semiconductor layer by using the photoresist layer as a mask, so that a portion of the semiconductor layer exposed by the second via V2 is subjected to the conductive treatment.

The step S43 includes forming a MoNb/Cu laminated structure, an MTD/Cu laminated structure or a MoNb/Cu/MTD laminated structure with a thickness in a range from 200 nm to 1200 nm, and patterning the laminated structure to form the adapter electrode 15 and the gate electrode 11, wherein the adapter electrode 15 is connected to the semiconductor layer through the second via V2 and is connected to the source electrode 13 through the first via V1.

The step S44 includes performing a conductive treatment on the semiconductor layer to form an active layer 12, where the active layer 12 includes a first conductive portion 121, a second conductive portion 122 and a channel portion 120 between the first conductive portion 121 and the second conductive portion 122, the first conductive portion 121 is connected to the adapter electrode 15, and the second conductive portion 122 serves as the drain electrode 14.

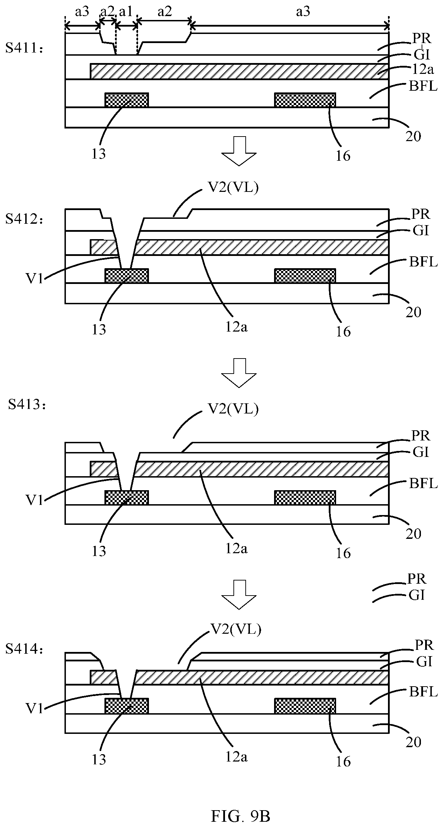

FIG. 9B is a schematic diagram illustrating a method for forming a second via in a gate insulating layer in step S41 of FIG. 9A. As shown in FIG. 9B, the step S41 may include steps S411 to S414.

The step S411 includes forming the photoresist layer on the gate insulating layer GI, and then exposing and developing the photoresist layer by using a halftone mask to remove the photoresist in the first region a1, and a portion of the photoresist in the second region a2, and maintain the photoresist in the third region a3. The first region a1 is a region corresponding to the first via V1, the second region a2 is a region except for the region corresponding to the first via V1 in a region where the second via V2 is located, and the third region a3 is a region except for the first region a1 and the second region a2.

The step S412 includes performing the first etching process to form the first via V1.

The step S413 includes performing the ashing process on the photoresist layer to remove the photoresist in the second region.

The step S414 includes performing the second etching process to form the second via V2 extending through the gate insulating layer GI.

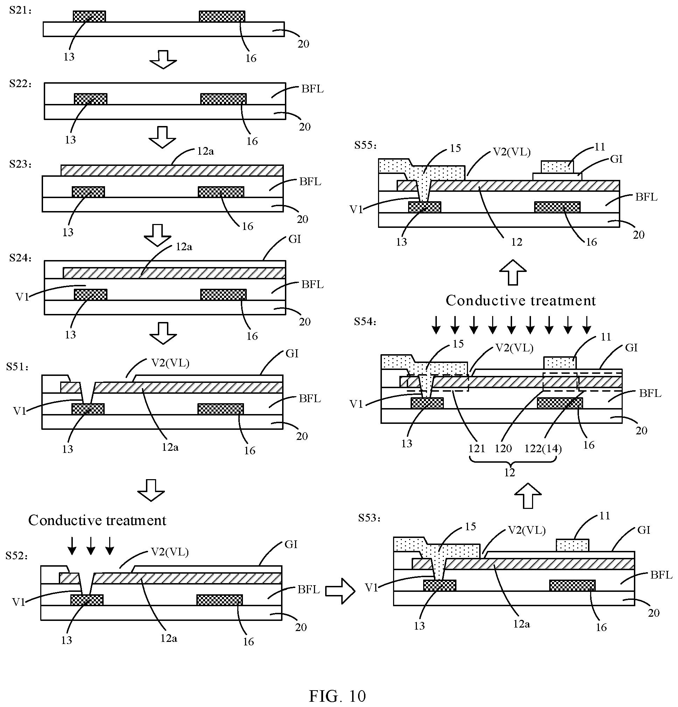

FIG. 10 is a schematic diagram illustrating a method for manufacturing a thin film transistor provided in a fourth example of the present disclosure. As shown in FIG. 10, the method for manufacturing a thin film transistor 10 includes the steps S20 to S24, and steps S51 to S55.

The step S51 includes synchronously forming the first via V1 and the second via V2. The detail of the step S41 refers to the description of the step S41, and is not described here again.

The step S52 includes performing a conductive treatment on the semiconductor layer by using the photoresist layer as a mask, so that a part of the semiconductor layer exposed by the second via V2 is subjected to the conductive treatment.

The step S53 includes forming a MoNb/Cu laminated structure, an MTD/Cu laminated structure or a MoNb/Cu/MTD laminated structure with a thickness in a range from 200 nm to 1200 nm, and patterning the laminated structure to form the adapter electrode 15 and the gate electrode 11, wherein the adapter electrode 15 is connected to the semiconductor layer 12a through the second via V2 and is connected to the source electrode 13 through the first via V1.

The step S54 includes performing a conductive treatment on the semiconductor layer 12a to form an active layer 12, where the active layer 12 includes a first conductive portion 121, a second conductive portion 122 and a channel portion 120 between the first conductive portion 121 and the second conductive portion 122, the first conductive portion 121 is connected to the adapter electrode 15, and the second conductive portion 122 serves as the drain electrode 14.

The step S55 includes etching the gate insulating layer GI, wherein the etched gate insulating layer GI is not in contact with the adapter electrode 15, and an orthographic projection of the gate insulating layer GI on the substrate 20 may coincide with or slightly exceed an orthographic projection of the gate electrode 11 on the substrate 20.

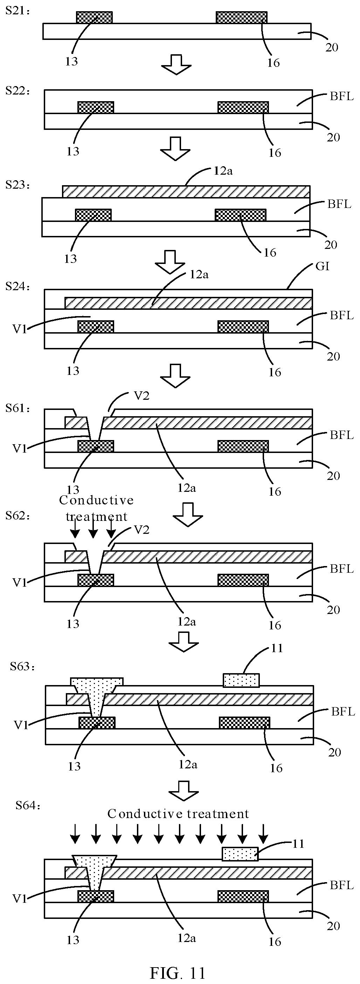

FIG. 11 is a schematic diagram illustrating a method for manufacturing a thin film transistor provided in a fifth example of the present disclosure. As shown in FIG. 11, the method for manufacturing a thin film transistor 10 includes the steps S20 to S24, and steps S61 to S64.

The step S61 includes etching a portion of the gate insulating layer GI corresponding to the source electrode 13 to form the second via V2 extending through the gate insulating layer GI, and then forming the first via V1 extending through the semiconductor layer 12a and the buffer layer BFL at the position of the second via V2 by etching. Since etching rates for the semiconductor layer 12a and the gate insulating layer GI are different, an aperture of the first via V1 formed by etching is smaller than that of the second via V2. A portion of the semiconductor layer 12a may be exposed by the second via V2.

The step S62 includes performing a conductive treatment on the part of the semiconductor layer 12a exposed by the second via V2 by using the mask used when forming the first via V1 and the second via V2.

The step S63 includes forming a MoNb/Cu laminated structure, an MTD/Cu laminated structure or a MoNb/Cu/MTD laminated structure with a thickness in a range from 200 nm to 1200 nm, and patterning the laminated structure to form the adapter electrode 15 and the gate electrode 11, wherein the adapter electrode 15 is connected to the semiconductor layer through the second via V2 and is connected to the source electrode 13 through the first via V1.

The step S64 includes performing a conductive treatment on the semiconductor layer to form an active layer 12, where the active layer 12 includes a first conductive portion 121, a second conductive portion 122 and a channel portion 120 therebetween, the first conductive portion 121 is connected to the adapter electrode 15, and the second conductive portion 122 serves as the drain electrode 14.

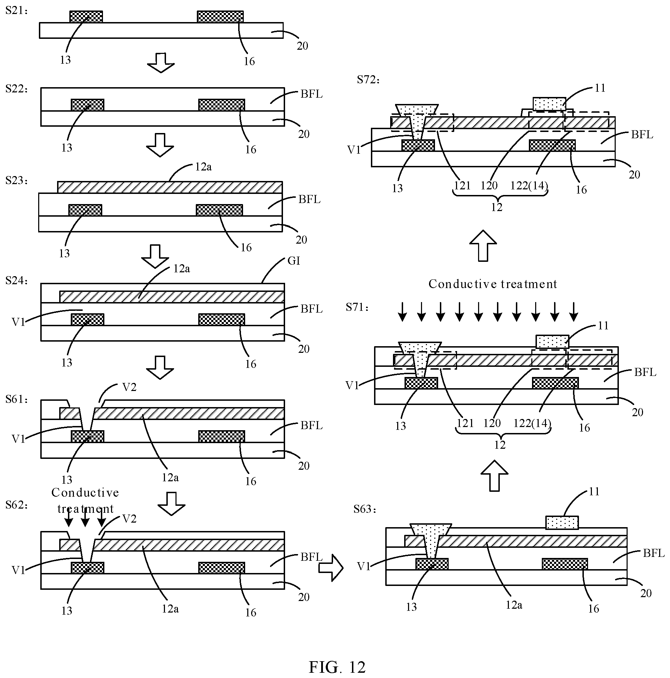

FIG. 12 is a schematic diagram illustrating a method for manufacturing a thin film transistor provided in a sixth example of the present disclosure. As shown in FIG. 12, the method for manufacturing a thin film transistor 10 includes the steps S20 to S24 and S61 to S63, and steps S71 to S72.

The step S71 includes performing a conductive treatment on the semiconductor layer to form an active layer 12, where the active layer 12 includes a first conductive portion 121, a second conductive portion 122 and a channel portion 120 between the first conductive portion 121 and the second conductive portion 122, the first conductive portion 121 is connected to the adapter electrode 15, and the second conductive portion 122 serves as the drain electrode 14.

The step S72 includes etching the gate insulating layer GI, wherein the etched gate insulating layer GI is not in contact with the adapter electrode 15, and an orthographic projection of the gate insulating layer GI on the substrate 20 may coincide with or slightly exceed an orthographic projection of the gate electrode 11 on the substrate 20.

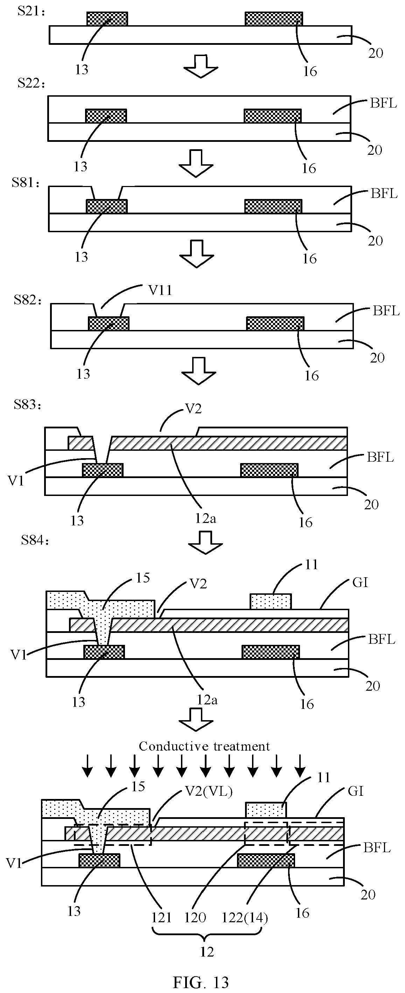

FIG. 13 is a schematic diagram illustrating a method for manufacturing a thin film transistor provided in a seventh example of the present disclosure. As shown in FIG. 13, the method for manufacturing a thin film transistor 10 includes the steps S20 to S22, and steps S81 to S85.

The step S81 includes etching the buffer layer BFL to form a first sub-via.

The step S82 includes forming a semiconductor layer 12a with a second sub-via therein, wherein the semiconductor layer 12a may be formed by a sputtering process, may be made of IGZO, and may have a thickness in a range from 10nm to 80 nm.

The step S83 includes forming a gate insulating layer GI. The detail of the step S83 refers to the description of the step S24, and is not described here again. The step S83 further includes etching the gate insulating layer GI to form the second via V2 extending through the gate insulating layer GI, wherein the second via V2 includes a third sub-via overlapping with the first sub-via, and the third sub-via is communicated with the second sub-via and the first sub-via to form the first via V1.

The step S84 includes forming a MoNb/Cu laminated structure, an MTD/Cu laminated structure or a MoNb/Cu/MTD laminated structure with a thickness in a range from 200 nm to 1200 nm, and patterning the laminated structure to form the adapter electrode 15 and the gate electrode 11, wherein the adapter electrode 15 is connected to the semiconductor layer through the second via V2 and is connected to the source electrode 13 through the first via V1.

The step S85 includes performing a conductive treatment on the semiconductor layer 12a to form an active layer 12, where the active layer 12 includes a first conductive portion 121, a second conductive portion 122 and a channel portion 120 between the first conductive portion 121 and the second conductive portion 122, the first conductive portion 121 is connected to the adapter electrode 15, and the second conductive portion 122 serves as the drain electrode 14.

It should be understood that the above embodiments are merely exemplary embodiments adopted to explain the principles of the present disclosure, and the present disclosure is not limited thereto. It will be apparent to one of ordinary skill in the art that various changes and modifications may be made therein without departing from the spirit and scope of the present disclosure, and such changes and modifications also fall within the scope of the present disclosure.

## Claims

1. A thin film transistor, comprising:
a gate electrode, an active layer, a source electrode and a drain electrode on a substrate, wherein the active layer is on a side of the source electrode away from the substrate, the gate electrode is on a side of the active layer away from the substrate, and the source electrode and the drain electrode are connected to the active layer;
a buffer layer between a layer where the active layer is located and a layer where the source electrode is located;
a gate insulating layer between the layer where the active layer is located and a layer where the gate electrode is located, and comprising a hollowed-out portion therein, and
an adapter electrode on a side of the active layer away from the substrate, wherein one part of the adapter electrode is electrically connected to the active layer through the hollowed-out portion and the other part of the adapter electrode is electrically connected to the source electrode through a first via, wherein the first via at least extends through the active layer and the buffer layer, and an orthographic projection of the first via on the substrate overlaps with an orthographic projection of the hollowed-out portion on the substrate.

2. The thin film transistor of claim 1, wherein the hollowed-out portion is a second via extending through the gate insulating layer, the orthographic projection of the first via on the substrate is a first projection, and an orthographic projection of the second via on the substrate is a second projection; and
the first projection is within the second projection; or one part of the second projection is within the first projection, and the other part of the second projection is located outside the first projection.

3. The thin film transistor of claim 2, wherein an orthographic projection of the adapter electrode on the substrate covers the second projection.

4. The thin film transistor of any one of claims 1 to 3, wherein the adapter electrode is in a same layer as the gate electrode.

5. The thin film transistor of claim 4, wherein the adapter electrode and the gate electrode are arranged in a first direction; and
a distance between the adapter electrode and the gate electrode in the first direction is in a range from 1µm to 3µm.

6. The thin film transistor of any one of claims 1 to 5, wherein the thin film transistor further comprises a light-shielding member between the active layer and the substrate, and an orthographic projection of the light-shielding member on the substrate at least partially overlaps with an orthographic projection of the active layer on the substrate.

7. The thin film transistor of claim 6, wherein the hollowed-out portion is a second via extending through the gate insulating layer; and
the orthographic projection of the light-shielding member on the substrate partially overlaps with the orthographic projection of the second via on the substrate.

8. The thin film transistor of claim 6 or 7, wherein the orthographic projection of the light-shielding member on the substrate overlaps with an orthographic projection of the adapter electrode on the substrate.

9. The thin film transistor of any one of claims 6 to 8, wherein the light-shielding member is in a same layer as the source electrode.

10. The thin film transistor of claim 9, wherein the light-shielding member and the source electrode are arranged in a first direction; and
a distance between the light-shielding member and the source electrode in the first direction is in a range from 1µm to 3µm.

11. The thin film transistor of any one of claims 1 to 10, wherein the active layer comprises a first conductive portion through which the first via extends, a second conductive portion serving as the drain electrode, and a channel portion between the first conductive portion and the second conductive portion.

12. The thin film transistor of claim 11, wherein the channel portion and the second conductive portion are arranged in a first direction, and the first conductive portion is strip-shaped and extends along the first direction.

13. The thin film transistor of claim 11 or 12, wherein
a distance between an orthographic projection of a part of the first conductive portion, which is in contact with the adapter electrode, on the substrate and an orthographic projection of the channel portion on the substrate, in the first direction, is in a range from 1µm to 4µm.

14. The thin film transistor of any one of claims 11 to 13, wherein a part of the adapter electrode connected to the active layer through the hollowed-out portion and a part of the adapter electrode connected to the source electrode through the first via are arranged in a first direction.

15. The thin film transistor of any one of claims 1 to 14, wherein an aperture of an end of the first via close to the substrate is less than 2µm; and
the buffer layer comprises a first portion covered by the active layer and a second portion which is not in contact with the active layer, the first portion has a first slope surface facing the first via and having a slope angle in a range from 70° to 90°, and the second portion has a second slope surface facing the first via and having a slope angle less than or equal to 60°.

16. The thin film transistor of any one of claims 1 to 15, wherein an orthographic projection of a bottom of the first via on the substrate is within a region covered by an orthographic projection of the source electrode on the substrate; and
a difference between a length of the source electrode in the first direction and a length of the bottom of the first via in the first direction is greater than or equal to 0.5µm.

17. The thin film transistor of any one of claims 1 to 16, wherein the buffer layer comprises a protrusion portion covering a portion of the source electrode close to the channel portion of the active layer.

18. The thin film transistor of claim 17, wherein a thickness of the protrusion portion in a direction perpendicular to the substrate is in a range from 1000µm to 20000µm.

19. The thin film transistor of claim 17 or 18, wherein a surface of the protrusion portion away from the substrate is an arc-shaped surface having a radian in a range from 15° to 90°.

20. The thin film transistor of any one of claims 1 to 19, wherein a portion of the adapter electrode in the first via is a third portion; and
a surface of the third portion away from the substrate is a convex surface protruding away from the substrate.

21. The thin film transistor of claim 20, wherein a difference between a maximum thickness and a minimum thickness of the third portion in the direction perpendicular to the substrate is in a range from 0.3 µm to 0.6 µm.

22. The thin film transistor of any one of claims 1 to 21, wherein the hollowed-out portion is a second via extending through the gate insulating layer; and
a difference between a slope angle of a slope surface of the gate insulating layer facing the second via and a slope angle of a slope surface of the active layer facing the first via is greater than or equal to 0° and less than or equal to 30°, and the slope surface of the gate insulating layer and the slope surface of the active layer are on a same side.

23. The thin film transistor of any one of claims 1 to 15, wherein the active layer is made of a metal oxide.

24. A display substrate, comprising: the thin film transistor of any one of claims 1 to 23.

25. The display substrate of claim 24, comprising a plurality of gate lines extending in the first direction and a plurality of data lines extending in a second direction on the substrate, which intersect with each other to define a plurality of pixel regions, wherein the thin film transistor is in each of the plurality of pixel regions;
the gate electrode of the thin film transistor is connected to a corresponding gate line of the plurality of gate lines, and the source electrode is connected to a corresponding data line of the plurality of data lines; and
the orthographic projection of the light-shielding member on the substrate does not overlap with an orthographic projection of the plurality of gate lines on the substrate.

26. A display apparatus, comprising the display substrate of claim 24 or 25.

27. A method for manufacturing the thin film transistor of any one of claims 1 to 23, comprising:
forming the source electrode, the buffer layer, the active layer, the drain electrode and the gate insulating layer on the substrate, respectively, wherein the drain electrode is connected to the active layer, the gate insulating layer is located on a side of the active layer away from the substrate, and comprises the hollowed-out portion therein;
forming the adapter electrode on a side of the active layer away from the substrate, wherein one part of the adapter electrode is electrically connected to the active layer through the hollowed-out portion and the other part of the adapter electrode is electrically connected to the source electrode through the first via, wherein the first via at least extends through the active layer and the buffer layer, and an orthographic projection of the first via on the substrate overlaps with an orthographic projection of the hollowed-out portion on the substrate; and
forming the gate electrode on a side of the gate insulating layer away from the substrate.

28. The method of claim 27, wherein the forming the gate insulating layer comprises:
forming a gate insulating material layer; and
patterning the gate insulating material layer to form the gate insulating layer comprising the hollowed-out portion, wherein the hollowed-out portion is a second via extending through the gate insulating layer, the orthographic projection of the first via on the substrate is a first projection, and an orthographic projection of the second via on the substrate is a second projection; and
wherein the first projection is within the second projection; or one part of the second projection is within the first projection, and the other part of the second projection is located outside the first projection.

29. The method of claim 28, wherein the active layer comprises a first portion to be processed, a second portion to be processed, and a channel portion between the first portion to be processed and the second portion to be processed, and a part of the first portion to be processed is exposed by the second via;
the method further comprises: performing a conductive treatment on the part of the first portion to be processed, which is exposed by the second via, and
performing a conductive treatment on the first portion to be processed and the second portion to be processed, wherein the second portion to be processed, which is subjected to the conductive treatment, functions as the drain electrode.

30. The method of claim 27, wherein the method further comprises forming a light-shielding member which is formed synchronously with the source electrode.
